(19)

Europäisches
Patentamt
European
Patent Office
Office européen
des brevets

(11) EP 4 608 085 A1

(12) **EUROPEAN PATENT APPLICATION**

(43) Date of publication:
27.08.2025 Bulletin 2025/35

(21) Application number: 25150075.7

(22) Date of filing: 02.01.2025

(51) International Patent Classification (IPC):
H10B 43/27 (2023.01)      H10D 64/01 (2025.01)

(52) Cooperative Patent Classification (CPC):
H10B 43/27; H10D 64/037

(84) Designated Contracting States:
AL AT BE BG CH CY CZ DE DK EE ES FI FR GB
GR HR HU IE IS IT LI LT LU LV MC ME MK MT NL
NO PL PT RO RS SE SI SK SM TR
Designated Extension States:
BA
Designated Validation States:
GE KH MA MD TN

(30) Priority: 26.02.2024 KR 20240027497

(71) Applicant: Samsung Electronics Co., Ltd.
Suwon-si, Gyeonggi-do 16677 (KR)

(72) Inventors:
• CHOI, Seokhoon
16678 Suwon-si (KR)
• LEE, Minhyun
16678 Suwon-si (KR)
• PARK, Jinjoo
16678 Suwon-si (KR)
• JANG, Seonghun
16678 Suwon-si (KR)

(74) Representative: Elkington and Fife LLP
Prospect House
8 Pembroke Road
Sevenoaks, Kent TN13 1XR (GB)

(54) **NON-VOLATILE MEMORY DEVICE, ELECTRONIC APPARATUS INCLUDING THE SAME, AND METHOD OF MANUFACTURING THE NON-VOLATILE MEMORY DEVICE**

(57)     A non-volatile memory device is provided. The non-volatile memory device may include a substrate, a gate electrode and a gate insulating layer that are alternately stacked on the substrate in a direction perpendicular to a top surface of the substrate, a channel hole that vertically penetrates the gate electrode and the gate insulating layer in the direction, a charge trap layer inside the channel hole and a channel layer in the charge trap layer, and the charge trap layer includes a nanocrystal region and an isolation region that are alternately arranged in the vertical direction.

FIG. 1

**Description**

FIELD OF THE INVENTION

Embodiments of the present disclosure relate to a non-volatile memory device with reduced lateral charge loss, an electronic apparatus including the same, and a method of manufacturing the non-volatile memory device.

BACKGROUND OF THE INVENTION

As hard disks are replaced with solid state drive (SSD), NAND flash memory devices, which are non-volatile memory devices, have been widely used. With the reduction in size and increase in integration of non-volatile memory devices, vertical NAND flash memory devices featuring a plurality of memory cells stacked in a direction perpendicular to a substrate have been developed.

As the demand for higher integration and lower power consumption increases, there is a growing interest in overcoming issues, such as high program/erase voltages, small memory windows, and data retention. In a non-volatile memory device, increased stacking levels of memory cells and decreased heights may lead to charge migration between the memory cells, and such migration may worsen charge retention of the memory cells.

SUMMARY OF THE INVENTION

According to embodiments of the present disclosure, a non-volatile memory device including a charge trap layer in which nanocrystal regions and isolation regions are alternately arranged is provided.

According to embodiments of the present disclosure, an electronic apparatus including a non-volatile memory device configured to reduce lateral charge loss, is provided.

According to embodiments of the present disclosure, a method of manufacturing a non-volatile memory device including a charge trap layer in which nanocrystal regions and isolation regions are alternately arranged is provided.

According to embodiments of the present disclosure, a non-volatile memory device may be provided and include: a substrate; a gate electrode and a gate insulating layer that are alternately stacked in a vertical direction perpendicular to a top surface of the substrate; a channel hole that penetrates the gate electrode and the gate insulating layer in the vertical direction; a charge trap layer inside the channel hole; a charge tunneling layer in the charge trap layer; and a channel layer in the charge tunneling layer, wherein the charge trap layer comprises a nanocrystal region and an isolation region that are alternately arranged in the vertical direction.

According to one or more embodiments of the present disclosure, the nanocrystal region may be at a location corresponding to the gate electrode, and the isolation region may be at a location corresponding to the gate insulating layer.

According to one or more embodiments of the present disclosure, the nanocrystal region may include MO (where M represents a metal) nanocrystals or MAO (where M represents a metal) nanocrystals, and A may include silicon (Si), boron (B), or aluminum (Al).

According to one or more embodiments of the present disclosure, M may include at least one from among hafnium (Hf), titanium (Ti), zirconium (Zr), uranium (U), thorium (Th), chromium (Cr), gallium (Ga), vanadium (V), scandium (Sc), lutetium (Lu), ytterbium (Yb), erbium (Er), holmium (Ho), dysprosium (Dy), gadolinium (Gd), europium (Eu), samarium (Sm), yttrium (Y), neodymium (Nd), cerium (Ce), lanthanum (La), nickel (Ni), magnesium (Mg), copper (Cu), zinc (Zn), cobalt (Co), iron (Fe), manganese (Mn), calcium (Ca), and strontium (Sr).

According to one or more embodiments of the present disclosure, the nanocrystal region may include a plurality of nanocrystals and a matrix surrounding the plurality of nanocrystals.

According to one or more embodiments of the present disclosure, the matrix may include $MSiO_2$ (where M represents a metal), $SiO_2$ doped with M, or $SiO_2$.

According to one or more embodiments of the present disclosure, a thickness of the channel hole at a vertical height of the nanocrystal region in a diameter direction of the channel hole may be in a range from 3 nm to 20 nm.

According to one or more embodiments of the present disclosure, a thickness of the isolation region of the charge trap layer in the vertical direction may be in a range from 5 nm to 25 nm.

According to one or more embodiments of the present disclosure, in the nanocrystal region, a quotient of a total volume of a plurality of nanocrystals in the nanocrystal region divided by a volume of the nanocrystal region may be at least 20%.

According to one or more embodiments of the present disclosure, the isolation region may include an amorphous region.

According to one or more embodiments of the present disclosure, the gate insulating layer may include $SiO_2$, a metal organic framework, or boron nitride.

According to one or more embodiments of the present disclosure, the non-volatile memory device may further include a charge blocking layer between the charge trap layer and the gate electrode.

According to one or more embodiments of the present disclosure, the nanocrystal region may include a plurality of nanocrystals, and a distance between the plurality of nanocrystals is in a range from 1 nm to 25 nm.

According to embodiments of the present disclosure, an electronic apparatus may be provided and include: a non-volatile memory device; and a memory controller configured to control the non-volatile memory device to read data from the non-volatile memory device or write data to the non-volatile memory device, wherein the non-volatile memory device comprises: a substrate; a gate electrode and a gate insulating layer that are alternately stacked on the substrate in a vertical direction perpendicular to a top surface of the substrate; a channel hole that penetrates the gate electrode and the gate insulating layer in the vertical direction; a charge trap layer inside the channel hole; a charge tunneling layer in the charge trap layer; and a channel layer in the charge tunneling layer, and wherein the charge trap layer comprises a nanocrystal region and an isolation region that are alternately arranged in the vertical direction.

According to one or more embodiments of the present disclosure, the nanocrystal region may be at a location corresponding to the gate electrode, and the isolation region may be at a location corresponding to the gate insulating layer.

According to one or more embodiments of the present disclosure, the nanocrystal region may include MO (where M represents a metal) nanocrystals or MAO (where M represents a metal) nanocrystals, and A may include at least one from among silicon (Si), boron (B), and aluminum (Al).

According to one or more embodiments of the present disclosure, M may include at least one from among hafnium (Hf), titanium (Ti), zirconium (Zr), uranium (U), thorium (Th), chromium (Cr), gallium (Ga), vanadium (V), scandium (Sc), lutetium (Lu), ytterbium (Yb), erbium (Er), holmium (Ho), dysprosium (Dy), gadolinium (Gd), europium (Eu), samarium (Sm), yttrium (Y), neodymium (Nd), cerium (Ce), lanthanum (La), nickel (Ni), magnesium (Mg), copper (Cu), zinc (Zn), cobalt (Co), iron (Fe), manganese (Mn), calcium (Ca), and strontium (Sr).

According to embodiments of the present disclosure, a method of manufacturing a non-volatile memory device may be provided and include: alternately stacking, on a substrate, a gate insulating layer and a mold layer in a vertical direction perpendicular to a top surface of the substrate; forming a channel hole that penetrates the gate insulating layer and the mold layer in the vertical direction; forming a sacrificial layer inside the channel hole; forming a charge tunneling layer in the sacrificial layer; forming a channel layer in the charge tunneling layer; forming, after forming the channel layer, a nanocrystal region in the sacrificial layer at a position corresponding to the mold layer, by inducing a reaction between the mold layer and the sacrificial layer via heating; forming an isolation region between the gate insulating layer and the mold layer; removing the mold layer; and forming a gate electrode in a space where the mold layer is removed, wherein the nanocrystal region and the isolation region are alternately arranged in the vertical direction such that a charge trap layer is formed.

According to one or more embodiments of the present disclosure, the mold layer may include MO, and M may include at least one from among hafnium (Hf), titanium (Ti), zirconium (Zr), uranium (U), thorium (Th), chromium (Cr), gallium (Ga), vanadium (V), scandium (Sc), lutetium (Lu), ytterbium (Yb), erbium (Er), holmium (Ho), dysprosium (Dy), gadolinium (Gd), europium (Eu), samarium (Sm), yttrium (Y), neodymium (Nd), cerium (Ce), lanthanum (La), nickel (Ni), magnesium (Mg), copper (Cu), zinc (Zn), cobalt (Co), iron (Fe), manganese (Mn), calcium (Ca), and strontium (Sr).

According to one or more embodiments of the present disclosure, the sacrificial layer may include at least one from among silicon (Si), boron (B), and aluminum (Al).

Additional aspects will be set forth in part in the description which follows and, in part, will be apparent from the description, or may be learned by practice of the non-limiting example embodiments of the present disclosure described in the description.

BRIEF DESCRIPTION OF DRAWINGS

The above and other aspects, features, and advantages of non-limiting example embodiments of the present disclosure will be more apparent from the following description taken in conjunction with the accompanying drawings, in which:

FIG. 1 schematically illustrates a non-volatile memory device according to an embodiment;
FIG. 2 is a cross-sectional view taken along a line A-A' of FIG. 1;
FIG. 3 illustrates an example in which a second charge blocking layer is further included, compared to FIG. 2;
FIG. 4 illustrates an example in which a diffusion prevention layer is further included, compared to FIG. 2;
FIGS. 5A to 5H are diagrams showing a method of manufacturing a non-volatile memory device, according to an embodiment;
FIGS. 6A to 6I are diagrams showing a method of manufacturing a non-volatile memory device, according to another embodiment;

FIG. 7 is a circuit diagram of a vertical non-volatile memory device, according to an embodiment;

FIG. 8 is a schematic block diagram of a display driver integrated circuit (IC) (DDI) and a display apparatus including the DDI, according to an embodiment;

FIG. 9 is a block diagram of an electronic apparatus according to an embodiment;

FIG. 10 is a block diagram of an electronic apparatus according to an embodiment;

FIG. 11 is a schematic conceptual view of a device architecture that may be applied to an electronic apparatus, according to an embodiment; and

FIG. 12 is a schematic conceptual view of a device architecture that may be applied to an electronic apparatus, according to an embodiment.

DETAILED DESCRIPTION

Reference will now be made in detail to embodiments, examples of which are illustrated in the accompanying drawings, wherein like reference numerals refer to like elements throughout. In this regard, the present embodiments may have different forms and should not be construed as being limited to the descriptions set forth herein. Accordingly, example embodiments are described below, by referring to the figures, to explain non-limiting example aspects of the present discourse. As used herein, the term "and/or" includes any and all combinations of one or more of the associated listed items. Expressions such as "at least one of," when preceding a list of elements, modify the entire list of elements and do not modify the individual elements of the list.

Hereinafter, a non-volatile memory device, an electronic apparatus including the non-volatile memory device, and a method of manufacturing the non-volatile memory device according to one or more non-limiting example embodiments are described in detail with reference to the attached drawings. The sizes of components in the drawings may be exaggerated for convenience of explanation. It will be understood that although the terms "first," "second," etc. may be used herein to describe various components, these components should not be limited by these terms. The terms are only used to distinguish one component from another.

As used herein, the singular forms "a," "an," and "the" are intended to include the plural forms as well, unless the context clearly indicates otherwise. It will be further understood that the terms "comprises" (or "includes") and/or "comprising" (or "including") used herein specify the presence of stated features or components, but do not preclude the presence or addition of one or more other features or components. Also, sizes or thicknesses of components in the drawings may be exaggerated for clarity. In addition, when a certain material layer is described as being present above a substrate or another layer, the material layer may be in direct contact with the substrate or the other layer, or there may be an intervening layer therebetween. Furthermore, materials forming each layer in the embodiments described below are merely examples, and thus, alternative materials may also be used.

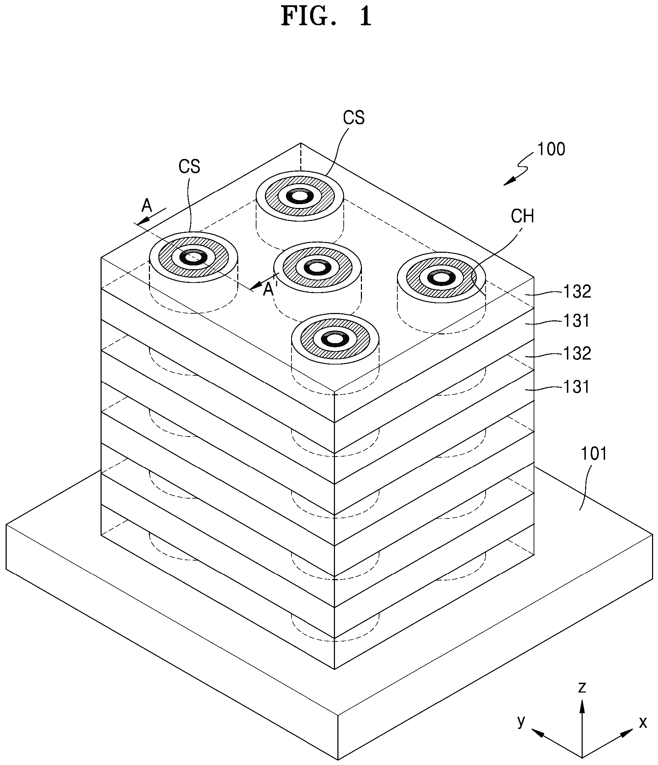

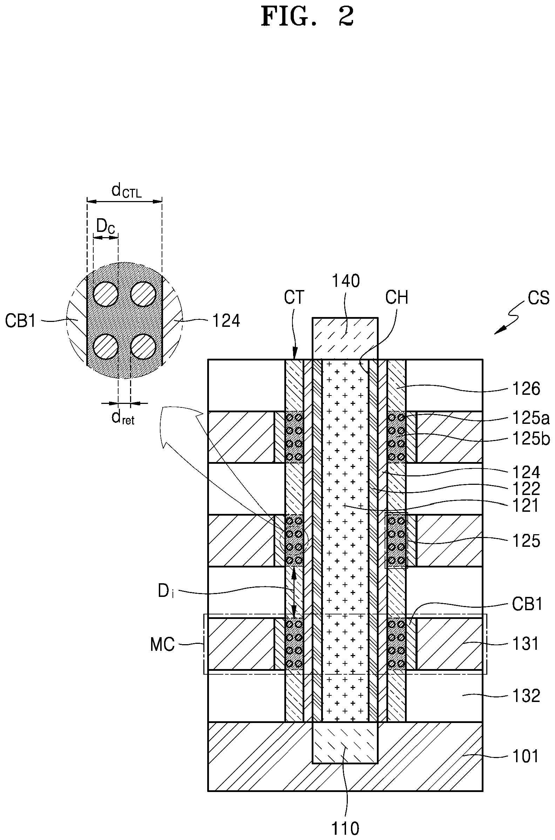

FIG. 1 is a schematic perspective view of a non-volatile memory device according to an embodiment, and FIG. 2 is a cross-sectional view taken along a line A-A' of FIG. 1.

Referring to FIG. 1, the non-volatile memory device 100 includes a plurality of cell strings CS arranged on a substrate 101. Here, each cell string CS may extend in a direction (a z-axis direction) that is perpendicular to the substrate 101 (e.g., a top surface of the substrate 101). The cell strings CS may be arranged on the substrate 101 in various forms. In the direction (the z direction) perpendicular to the substrate 101, gate electrodes 131 and gate insulating layers 132 may be alternately stacked. Channel holes CH may penetrate through a stack structure including the gate electrodes 131 and the gate insulating layers 132 in the direction (the z-axis direction) that is perpendicular to the substrate 101. The channel hole CH may be formed to have, for example, a circular cross-section. However, the cross-sectional shape of the channel hole CH is not limited thereto.

The cell string CS may have a stack structure of multiple cylindrical shells in the channel hole CH. However, the structure of the cell string CS is not limited thereto, and the cell string CS may have different shapes and structures.

Referring to FIG. 2, a charge trap layer CT is included inside the channel hole CH, a charge tunneling layer 124 is included in the charge trap layer CT, and a channel layer 122 is included in the charge tunneling layer 124. The channel layer 122 may include a pillar 121.

The charge trap layer CT may include nanocrystal regions 125 and isolation regions 126 that are alternately arranged in the direction perpendicular to the substrate 101 (e.g., the top surface of the substrate 101).

The cell string CS may include a plurality of memory cells MC stacked in the direction (the z-axis direction) that is perpendicular to the substrate 101. The memory cell MC may serve as a basic unit cell that writes and erases data.

The substrate 101 may include a single-crystal silicon substrate, a compound semiconductor substrate, or a silicon-on-insulator (SOI) substrate, but is not limited thereto. In addition, the substrate 101 may further include a periphery circuit configured to select and control, for example, impurity regions generated by doping, electronic devices such as transistors, or memory cells storing data.

The pillar 121 may include, for example, silicon oxide or air, but one or more embodiments are not limited thereto. The channel layer 122, the charge tunneling layer 124, and the charge trap layer CT may extend perpendicularly from the substrate 101 and may be shared by a plurality of memory cells MC.

The channel layer 122 may include a semiconductor material. The channel layer 122 may include, for example, silicon (Si), germanium (Ge), SiGe, or a group III-V semiconductor. Also, the channel layer 122 may include, for example, an oxide semiconductor, a nitride semiconductor, an oxynitride semiconductor, a two-dimensional (2D) semiconductor material, a quantum dot, or an organic semiconductor. Here, the oxide semiconductor may include, for example, InGaZnO. The 2D semiconductor material may include, for example, transition metal dichalcogenide (TMD) or graphene, and the quantum dot (QD) may include colloidal QD, a nanocrystal structure, or the like. The 2D semiconductor material refers to a semiconductor material having a 2D crystal structure and may have a monolayer structure or a multilayer structure. The 2D semiconductor material may be applied to various devices because of its excellent electrical properties and ability to maintain high mobility without significant changes even when the thickness of the 2D semiconductor material is reduced to the nanoscale dimensions. Each layer forming the 2D semiconductor material may have a thickness on an atomic level. The channel layer 122 may include, for example, 1 to 10 layers of 2D semiconductor material. However, one or more embodiments are not limited thereto.

The 2D semiconductor material may include, for example, at least one from among graphene, black phosphorous, and TMD. Graphene refers to a material with a hexagonal honeycomb structure including carbon atoms bonded in two dimensions, offering advantages over Si, for example, higher electrical mobility, greater thermal properties, chemical stability, and greater surface area. Black phosphorous refers to a material including black phosphorous atoms that are two-dimensionally bonded.

TMD may be represented as, for example, $MX_2$, where M indicates transition metal and X indicates a chalcogen element. For example, M may include molybdenum (M), tungsten (W), niobium (Nb), vanadium (V), tantalum (Ta), titanium (Ti), zirconium (Zr), hafnium (Hf), technetium (Tc), or rhenium (Re), and X may include sulfur (S), selenium (Se), or tellurium (Te). Therefore, TMD may include, for example, $MoS_2$, $MoSe_2$, $MoTe_2$, $WS_2$, $WSe_2$, $WTe_2$, $ZrS_2$, $ZrSe_2$, $HfS_2$, $HfSe_2$, $NbSe_2$, or $ReSe_2$.

Alternatively, the 2D semiconductor material may include CuS that is a compound consisting of the transition metal, copper (Cu), and chalcogen element, S. The 2D semiconductor material may be a chalcogenide material including a non-transition metal. Non-transition metals may include, for example, gallium (Ga), indium (In), tin (Sn), Ge, or lead (Pb). In this case, the 2D semiconductor material may include a compound consisting of non-transition metals, such as Ga, In, Sn, Ge, or Pb, and chalcogenide elements, such as S, Se, or Te. For example, the 2D semiconductor material may include $SnSe_2$, GaS, GaSe, GaTe, GeSe, $In_2Se_3$, $InSnS_2$, or the like. However, the aforementioned materials are merely examples, and alternative materials may be used as 2D semiconductor materials.

The channel layer 122 may further include dopants. Here, the dopant may include a p-type dopant or an n-type dopant. A p-type dopant may include, for example, a group III element, such as boron (B), aluminum (Al), Ga, or In, and an n-type dopant may include, for example, a group V element, such as phosphorus (P), arsenic (As), or antimony (Sb).

The charge tunneling layer 124 may be a layer where charge tunneling occurs and may include, for example, $SiO_2$ or metal oxide. However, one or more embodiments are not limited thereto.

The gate electrodes 131 may be stacked apart from each other in a direction perpendicular to the substrate 101 (e.g., the top surface of the substrate 101), and the gate insulating layer 132 may be between the gate electrodes 131. The gate insulating layer 132 may include an insulating material and may separate the gate electrodes 131 from each other, allowing for independent operation of the gate electrodes 131 in units of memory cells MC. FIG. 2 illustrates a source electrode 110 and a drain electrode 140. The source electrode 110 is arranged under the channel layer 122, and the drain electrode 140 may be arranged above the channel layer 122. The drain electrode 140 may be connected to a bit line.

FIG. 2 illustrates that a respective source electrode 110 is connected to each cell string CS, but a single source electrode 110 may be commonly connected to each cell string CS.

Referring to the overall structure, the channel layer 122 surrounds the side surfaces of the pillar 121, the charge tunneling layer 124 surrounds the side surfaces of the channel layer 122, and the charge trap layer CT surrounds the side surfaces of the charge tunneling layer 124.

Additionally, the gate electrodes 131 and the gate insulating layers 132 may be alternately arranged perpendicularly to the substrate 101, and a first charge blocking layer CB1 may be between the charge trap layer CT and the gate electrode 131. The first charge blocking layer CB1 may be arranged discontinuously in the direction perpendicular to the substrate 101. The first charge blocking layer CB1 may be at locations corresponding to the gate electrodes 131.

Respective channels corresponding to the gate electrodes 131 may be formed on the channel layer 122 that is between the source electrode 110 and the drain electrode 140. When a certain voltage is applied to the gate electrode 131 in each memory cell MC, charges flowing between the source electrode 110 and the drain electrode 140 in the channel layer 122 corresponding to the gate electrode 131 pass through the charge tunneling layer 124 and are captured in the charge trap layer CT such that information may be stored.

The gate electrode 131 may control its corresponding channel layer 122, and a word line may be electrically connected to the gate electrode 131. The gate electrode 131 may include a metal material with great electrical conductivity, conductive oxide, metal nitride, silicon doped with impurities, a 2D semiconductor material, or the like. The metal material and the metal nitride may each include, for example, gold (Au), Ti, titanium nitride (TiN), tantalum nitride (TaN), W, Mo, tungsten nitride (WN), platinum (Pt), Ni, or any combination thereof. The conductive oxide may include, for example, indium tin oxide (ITO) or indium zinc oxide (IZO). However, one or more embodiments are not limited thereto, and the gate electrode 131 may include various materials. The gate insulating layer 132 may function as a spacer layer to insulate the gate electrodes 131 from each other. The gate insulating layer 132 may include, for example, $SiO_2$, SiN, a metal organic framework, or boron nitride (BN). The metal organic framework may include a porous solid material synthesized through self-assembly based on metal nodes and organic ligands. The metal organic framework may include, for example, UiO-66 or ZIF-8. BN may include amorphous BN or amorphous boron carbon nitride (BCN).

The first charge blocking layer CB1 may function as a barrier that interrupts charge migration between the charge trap layer CT and the gate electrodes 131. A surface of the first charge blocking layer CB1 may be in contact with the charge trap layer CT, and an opposite surface thereof may be in contact with the gate electrode 131.

The charge trap layer CT may store introduced charges. Charges (e.g., electrons) existing in the channel layer 122 may be transferred to the charge trap layer CT due to the tunneling effect. The charges introduced to the charge trap layer CT may be fixed thereto.

The charge trap layer CT may include nanocrystal regions 125 and isolation regions 126. The nanocrystal region 125 may be at locations corresponding to the gate electrodes 131, and the isolation region 126 may be at locations corresponding to the gate insulating layers 132.

The nanocrystal region 125 may include nanocrystals 125a and a matrix 125b surrounding the nanocrystals 125a. The nanocrystals 125a may include materials with excellent charge trap properties, and the matrix 125b may include materials with superior charge migration blocking characteristics. A material forming the nanocrystal 125a may have a higher trap density than a trap density of the matrix 125b.

The nanocrystal 125a may include MO or MAO nanocrystals, where M represents a metal. Here, M may include at least one from among Hf, Ti, Zr, uranium (U), thorium (Th), chromium (Cr), Ga, V, scandium (Sc), lutetium (Lu), ytterbium (Yb), erbium (Er), holmium (Ho), dysprosium (Dy), gadolinium (Gd), europium (Eu), samarium (Sm), yttrium (Y), neodymium (Nd), cerium (Ce), lanthanum (La), nickel (Ni), magnesium (Mg), Cu, zinc (Zn), cobalt (Co), iron (Fe), manganese (Mn), calcium (Ca), and strontium (Sr). A may include at least from among Si, B, and Al. The nanocrystal region 125 may include, for example, hafnium oxide (HfO) nanocrystals or hafnium silicate (HfSiO) nanocrystals. The matrix 125b may include at least one from among Si, Al, and B. The matrix 125b may include, for example, $MSiO_2$ (where M represents a metal), $SiO_2$ doped with M, or $SiO_2$. The isolation region 126 may include silixon oxide (SiO), boron oxide (BO), or aluminum oxide (AIO).

The nanocrystal 125a may have, for example, a spherical type, an oval type, a disk type, or a rod type. The nanocrystal 125a may have a nano size. Here, the size of the nanocrystal 125a may be defined as follows according to the shape of the nanocrystal 125a. When the shape of the nanocrystal 125a is a sphere or an oval, the size of the nanocrystal 125a may refer to the average diameter thereof. When the shape of the nanocrystal 125a is a disk, the size of the nanocrystal 125a refers to the thickness thereof. When the shape of the nanocrystal 125a is a rod, the size of the nanocrystal 125a refers to the diameter of a cross-section of the nanocrystal 125a.

The nanocrystal 125a may have a diameter Dc in a range from about 1 nm to about 20 nm. The nanocrystal 125a may have a diameter Dc in a range from about 2 nm to about 18 nm. A distance $d_{ret}$ between adjacent nanocrystals 125a may range from about 1 nm to about 25 nm. The distance $d_{ret}$ may represent the minimum distance between surfaces of the adjacent nanocrystals 125a.

In the nanocrystal region 125, (the total volume of nanocrystals)/(the volume of the nanocrystal region) may be about 20 % or greater. (The total volume of nanocrystals)/(the volume of the nanocrystal region) may be in a range from about 30% to about 90%. (The total volume of nanocrystals)/(the volume of the nanocrystal region) may be in a range from about 40% to about 80%. In addition, the thickness $d_{CTL}$ of the channel hole CH at a vertical level of the nanocrystal region 125 in the diameter direction may be in a range from about 3 nm to about 20 nm.

The thickness $D_i$ at a vertical level the isolation region 126 in the vertical direction (the Z direction) may be in a range from about 5 nm to about 25 nm. The isolation region 126 may be an amorphous region. The isolation region 126 may include at least one from among SiO, AIO, and BO.

Because of the diffusion of metallic elements M from the nanocrystal region 125 to the isolation region 126, the metallic elements M may be included in the isolation region 126. The difference in the content of metallic elements M between the nanocrystal region 125 and the isolation region 126 may be at least 5 atomic percent (at%). For example, the Hf content in the isolation region 126 may be less than the Hf content in the nanocrystal region 125, and the Hf content difference may be at least 5 at%.

The charge trap layer CT may be formed through spinodal decomposition during thermal treatment. Spinodal decomposition may occur when formation energy, that is, Gibbs free-energy change $\Delta G$, is greater than 0, wherein the formation energy is generated from the combination of materials forming the charge trap layer CT at a specific temperature. The shapes and sizes of the nanocrystals 125a may be adjusted depending on the thermal-treatment temperature applied to the materials forming the charge trap layer CT.

A reliability factor for non-volatile memory devices is a data retention property, specifically, the ability to store charges in the charge trap layer CT for a long period of time. When the distance between the memory cells MC is reduced to increase the memory density in the non-volatile memory device, charges trapped between the memory cells MC may move, and thus, charge retention characteristics may degrade.

In a direction perpendicular to the charge trap layer CT, the charges may move from the charge trap layer CT to the charge tunneling layer 124 through trap-assisted tunneling or thermal emission. The movement degree of charges may be determined based on a conduction band offset (CBO) on an interface between the charge trap layer CT and the charge tunneling layer 124.

In a direction parallel to the charge trap layer CT, charge migration may occur due to lateral migration according to a gradient in charge density. The charge migration in the direction parallel to the charge trap layer CT may be dominated by Poole-Frenkel tunneling. The current density resulting from Poole-Frenkel tunneling may be expressed using Poole-Frenkel Conduction Equation (equation 1) below.

$$J = q\mu N_c E \exp\left(\frac{-q(E_T - \sqrt{qE/\pi\varepsilon})}{kT}\right) \qquad \text{(equation 1)}$$

(J : current density, q : electronic charge, $\mu$ : carrier mobility $N_c$ : density of states in conduction band, E : electric field, $E_T$ : trap energy, $\varepsilon$ : permittivity, k : Boltzmann constant, T : temperature)

The charge migration in the direction parallel to the charge trap layer CT by Poole-Frenkel tunneling may be determined by trap energy $E_T$ and trap density $N_T$ in the charge trap layer CT. Trap energy refers to the voltage barrier that electrons need to cross to move from one atom to another atom within the material. That is, trap energy refers to the depth of a trap state relative to a conduction band minimum (CBM) of a material. Trap density is defined as the number of charges trapped per unit volume. The trap density may be calculated based on a charge pumping method. The charge retention characteristics in the direction parallel to the charge trap layer CT may be improved by high trap energy and high trap density.

When the charge trap layer CT exhibits a continuously identical molecular structure distribution across multiple memory cells MC, the trapped charges may spread out to adjacent memory cells MC, and thus, the lateral charge loss may occur. Conversely, as in the present embodiment, when the charge trap layer CT has a discontinuous structure including the nanocrystal region 125 and the isolation region 126, the charge loss path is blocked, thereby reducing lateral charge loss. In addition, because the charge loss path is blocked by the isolation region 126, the nanocrystal density in the nanocrystal region 125 may increase, and thus, the trap density in the nanocrystal region 125 may also increase.

As the non-volatile memory device is highly integrated and has a decreased size, the increase in the lateral charge loss between the memory cells MC may be effectively restricted by the isolation region 126.

As the charge trap layer CT includes the nanocrystal region 125 and the isolation region 126, trap energy and trap density may increase, and the charge retention characteristics may be improved by controlling the migration of charges trapped between the memory cells MC. Therefore, the memory operation characteristics may be improved as the threshold voltage is reduced.

The first charge blocking layer CB1 may prevent charges from leaking to the gate insulating layer 132 and the gate electrode 131 over the charge trap layer CT. The first charge blocking layer CB1 may be in direct contact with the nanocrystal region 125 of the charge trap layer CT. However, one or more embodiments are not limited thereto, and an intervening layer may be present between the charge trap layer CT and the first charge blocking layer CB1. The first charge blocking layer CB1 may include $SiO_2$, metal oxide, or metal nitride, but one or more embodiments are not limited thereto. The first charge blocking layer CB1 may include at least one from among aluminium oxide (AlO), magnesium oxide (MgO), aluminum nitride (AlN), and gallium nitride (GaN). The first charge blocking layer CB1 may include, for example, $SiO_2$ or $Al_2O_3$.

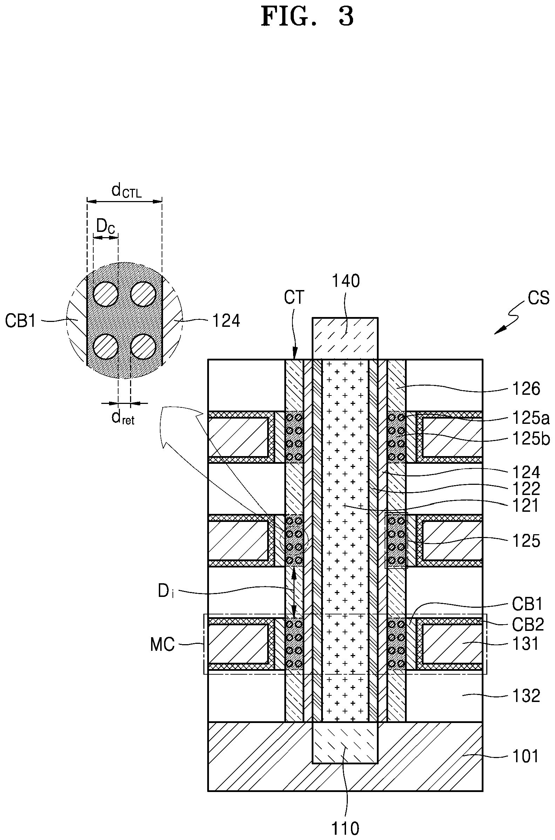

Compared to FIG. 2, FIG. 3 illustrates that a second charge blocking layer CB2 is further included. In FIG. 3, components referred to with the same reference numerals as in FIG. 2 may have the same configuration and effects, and thus, repeated descriptions thereof may be omitted.

The second charge blocking layer CB2 may include a ferroelectric material or an antiferroelectric material. The second charge blocking layer CB2 may be between the gate electrode 131 and the gate insulating layer 132 and between the gate electrode 131 and the first charge blocking layer CB1. However, one or more embodiments are not limited thereto, and the second charge blocking layer CB2 may be arranged only between the gate electrode 131 and the first charge blocking layer CB1. Alternatively, the positions of the first charge blocking layer CB1 and the second charge blocking layer CB2 may be changed. Alternatively, the first charge blocking layer CB1 may surround the second charge blocking layer CB2.

A ferroelectric material is a substance with ferroelectricity that maintains spontaneous polarization as electrical dipole moments are aligned without the need for an external electric field. A ferroelectric material exhibits spontaneous polarization as its permanent dipoles are aligned in parallel in the same direction. A ferroelectric material may have remanent polarization because of dipoles even without an external electric field. In addition, the polarization direction may switch at the domain level because of an external electric field. According to the polarization direction of the ferroelectric material, for example, the direction from the gate electrode 131 to the channel layer 122 or the direction from the channel layer 122 to the gate electrode 131, the threshold voltage of the non-volatile memory device 100 may change.

An antiferroelectric material may include an array of electric dipoles, but the remanent polarization may be 0 or close to 0. In the absence of an electric field, because the polarization may be offset by opposing orientations of adjacent dipoles, the overall spontaneous polarization or remanent polarization may be 0 or near 0. However, when an external electric field is applied, an antiferroelectric material may exhibit polarization characteristics and switching characteristics.

The ferroelectric material may include HfO material or an AlN material. The ferroelectric material may have a configuration in which dopants are inserted into an HfO-based material or an AlN-based material. When the ferroelectric material is based on HfO, the dopant may be Zr, La, Al, Si, or Y. When the ferroelectric material is based on AlN, the dopant may be B or Sc.

Alternatively, the ferroelectric material may include a ferroelectric material having, for example, at least one from among a fluorite structure, a perovskite structure, and a wurtzite structure.

The ferroelectric material with the fluorite structure may include, for example, $HfO_2$ or $ZrO_2$. Here, $HfO_2$ or $ZrO_2$ may have a crystal structure belonging to the tetragonal system or the orthorhombic system. The crystal structure of the tetragonal system may exhibit anti-ferroelectricity, and the crystal structure of the orthorhombic system may exhibit ferroelectricity. Undoped $HfO_2$ may have a stable tetragonal crystal structure but may have an orthorhombic crystal structure depending on the sizes of crystal grains. Undoped $ZrO_2$ may have a stable crystal structure of the tetragonal system. Undoped $HfO_2$ or $ZrO_2$ may include nanocrystals having grain sizes ranging, for example, from about 1 nm to about 3 nm, but one or more embodiments are not limited thereto.

The fluorite-based material may include, for example, $HfO_2$ or $ZrO_2$ including dopants. Here, the dopants may include, for example, at least one from among Al, Ga, Co, Ni, Mg, In, La, Y, Nd, Sm, Er, Sr, Ba, Gd, Ge, N, and Si. However, one or more embodiments are not limited thereto. $HfO_2$ or $ZrO_2$ including dopants may have a crystal structure of the tetragonal system with anti-ferroelectricity or the crystal structure of the orthorhombic system with ferroelectricity, depending on the grain sizes and doping concentrations. The crystal structure of the tetragonal system may be stable as the grain size is small or the doping concentration is high, and the crystal structure of the orthorhombic system may be stable as the grain size is great and the doping concentration is low.

$HfO_2$ or $ZrO_2$ that is doped with dopants may include nanocrystals having greater grain sizes than undoped $HfO_2$ or $ZrO_2$. For example, $HfO_2$ or $ZrO_2$ doped with dopants may have grain sizes ranging from about 4 nm to about 7 nm or from about 4 nm to about 5 nm, but one or more embodiments are not limited thereto.

The dopant concentration may vary depending on the dopant types. For example, when the dopant is Si, the doping concentration may be between about 1 at% to about 5 at%. However, one or more embodiments are not limited thereto.

Ferroelectric materials with a perovskite structure may include substances with an $M^1M^2O_3$ composition (where $M^1, M^2$ is a metallic element). Perovskite-based materials may include, for example, at least one from among PbZrOs, PbTiOs, BaTiOs, SrTiOs, and CaTiOs. However, one or more embodiments are not limited thereto. Perovskite-based materials may have a tetragonal crystal structure with anti-ferroelectricity or an orthorhombic crystal structure with ferroelectricity, depending on the composition ratios of constituting elements.

Wurtzite-based materials may include undoped AlN, AlN including GaN, InN, or dopants, GaN, or InN. The dopant may include at least one from among B and Sc.

For example, the second charge blocking layer CB2 may include hafnium zirconium oxide (HfZrO), and Zr/(Hf+Zr) may be in a range from about 20 at% to about 80 at%.

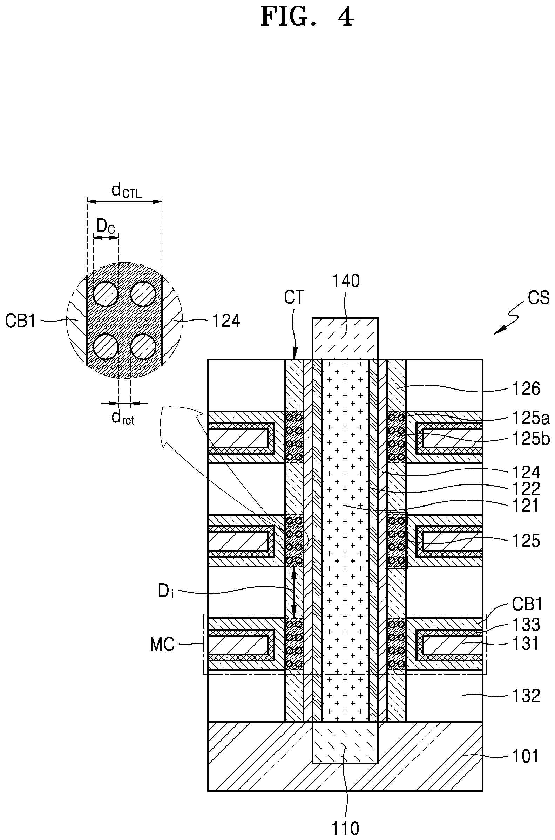

FIG. 4 illustrates that a diffusion prevention layer 133 may be further included. The first charge blocking layer CB1 may be arranged to surround the side surfaces of the gate electrode 131. The diffusion prevention layer 133 may be between the first charge blocking layer CB1 and the gate electrode 131. The diffusion prevention layer 133 may prevent reactions and diffusion at the interface between the gate electrode 131 and the gate insulating layer 132 or between the gate electrode 131 and the charge trap layer CT. The diffusion prevention layer 133 may include a material with a greater oxidation reduction potential than an oxidation reduction potential of the gate insulating layer 132. The diffusion prevention layer 133 may include at least one from among Ti, Zr, V, Al, La, Nb, and Ta or include nitride including at least one of among above-listed elements. The diffusion prevention layer 133 may include, for example, titanium nitride (TiN) or niobium nitride (NbN).

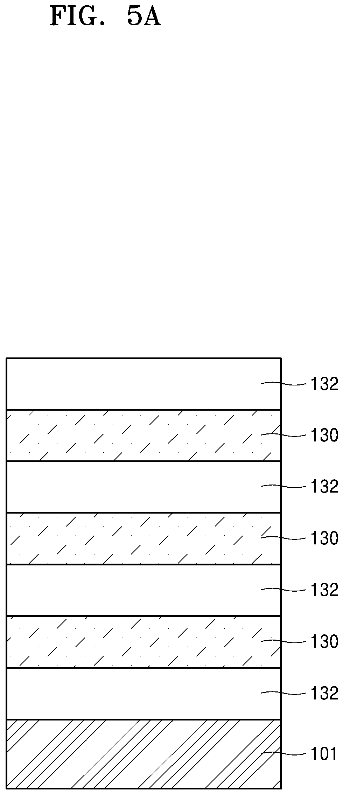

Next, referring to FIGS. 5A to 5H, a method of manufacturing a non-volatile memory device according to an embodiment is described.

Referring to FIG. 5A, gate insulating layers 132 and mold layers 130 are alternately stacked on a substrate 101 in a direction perpendicular to the substrate 101 (e.g., the top surface of the substrate 101). The gate insulating layer 132 may include, for example, $SiO_2$ or SiN, but one or more embodiments are not limited thereto. The gate insulating layer 132 may include, for example, $SiO_2$. The mold layer 130 may include MO (where M represents a metal), and M includes at least one from among Hf, Ti, Zr, U, Th, Cr, Ga, V, Sc, Lu, Yb, Er, Ho, Dy, Gd, Eu, Sm, Y, Nd, Ce, La, Ni, Mg, Cu, Zn, Co, Fe, Mn, Ca, and Sr. The mold layer 130 may include, for example, $HfO_2$.

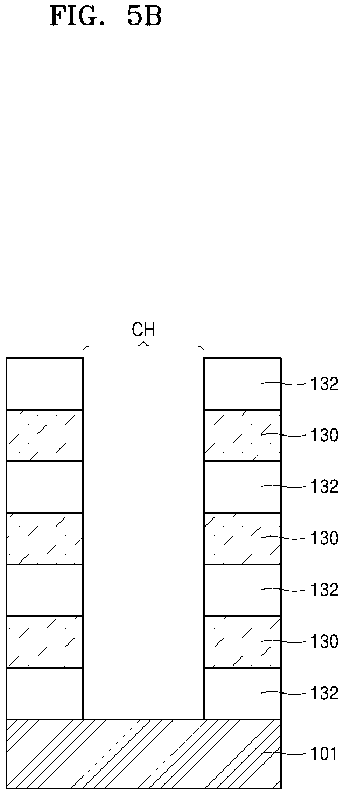

Referring to FIG. 5B, a channel hole CH is formed to penetrate the stack structure of the gate insulating layers 132 and the mold layers 130. The channel hole CH may extend in the direction perpendicular to the surface of the substrate 101. The channel hole CH may have a circular cross-section. The channel hole CH may be formed by anisotropically etching the gate insulating layers 132 and the mold layers 130.

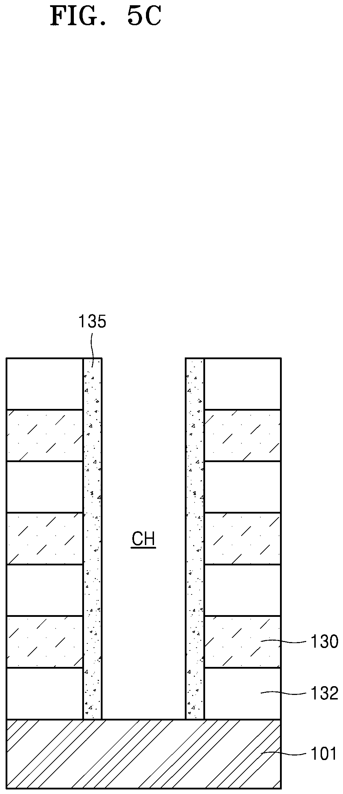

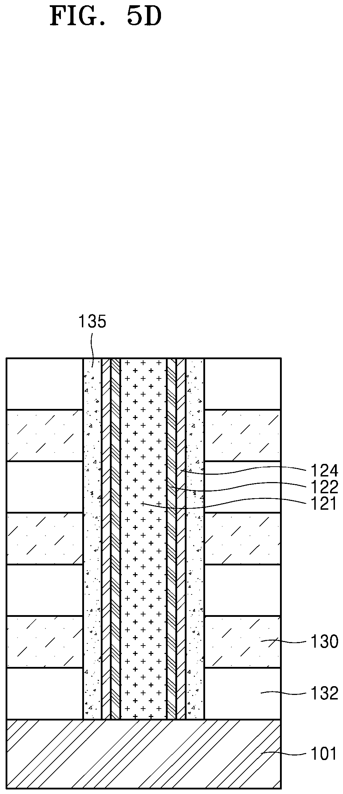

Referring to FIG. 5C, a sacrificial layer 135 may be formed in the channel hole CH. The sacrificial layer 135 may include, for example, at least one from among Si, B, and Al. Referring to FIG. 5D, a charge tunneling layer 124 and a channel layer 122 may be formed on the sacrificial layer 135. The pillar 121 may be formed in the channel layer 122.

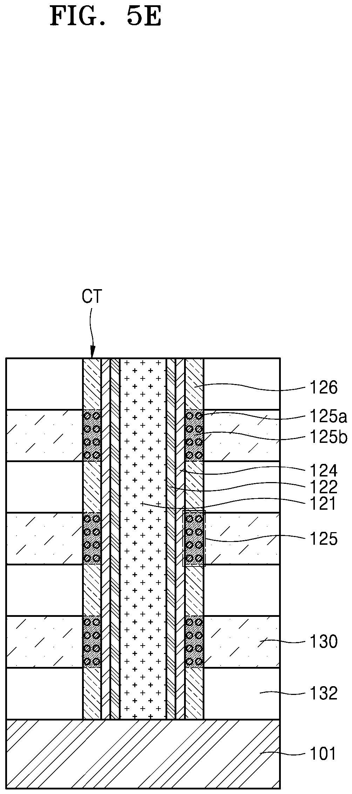

Referring to FIG. 5E, when the structure of FIG. 5D is thermally treated in an oxygen atmosphere, a reaction between the sacrificial layer 135 and the mold layer 130 results in spinodal decomposition, thereby forming nanocrystal regions 125 in the sacrificial layer 135. A simple oxidation reaction occurs between the gate insulating layers 132 and the sacrificial layer 135, and thus, isolation regions 126 are formed. The stack structure, in which the nanocrystal regions 125 and the isolation regions 126 are alternately formed, may form the charge trap layer CT. The nanocrystal region 125 may include nanocrystals 125a and a matrix 125b surrounding the nanocrystals 125a. The isolation region 126 may be an amorphous region.

The nanocrystal 125a may include Mo or MAO (where M represents a metal) nanocrystals. Here, M may include at least one from among Hf, Ti, Zr, U, Th, Cr, Ga, V, Sc, Lu, Yb, Er, Ho, Dy, Gd, Y, Nd, Ce, La, Ni, Mg, Cu, Zn, Co, Fe, Mn, Ca, Eu, Sr, and Sm. A may include at least one from among Si, B, and Al. The nanocrystal region 125 may include, for example, HfO nanocrystals or HfSiO nanocrystals. Alternatively, the nanocrystal region 125 may include A-doped $HfO_2$ nanocrystals. The matrix 125b may include, for example, $MSiO_2$ (where M represents a metal), $SiO_2$ doped with M, or $SiO_2$ The isolation region 126 may include SiO, BO, or AlO.

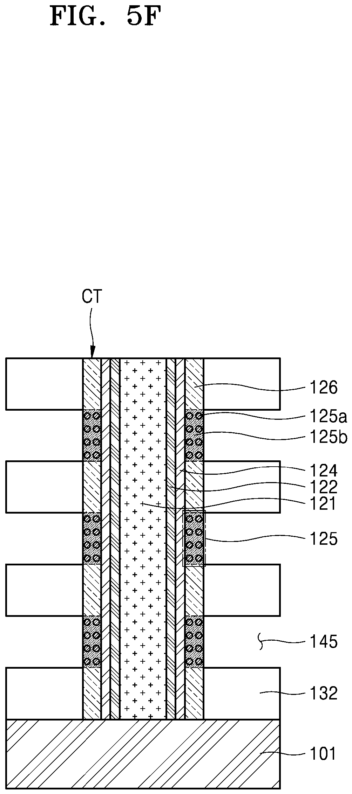

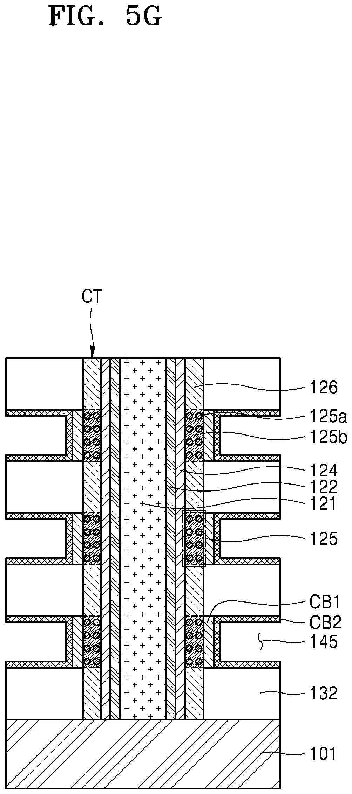

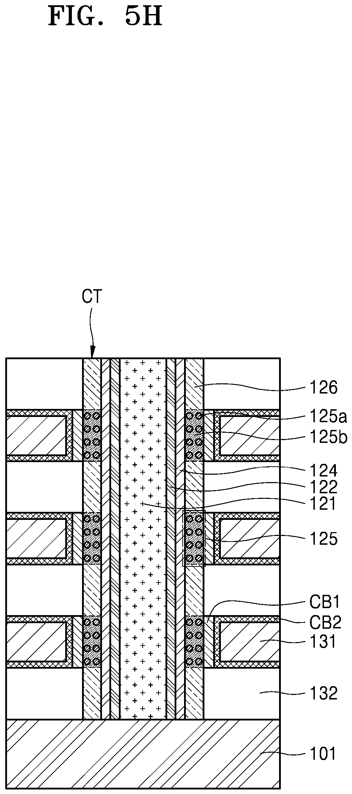

Referring to FIG. 5F, the mold layer 130 is removed through selective etching. Referring to FIG. 5G, in the space 145 where the mold layer 130 is removed, the first charge blocking layer CB1 and the second charge blocking layer CB2 are formed. The first charge blocking layer CB1 and the second charge blocking layer CB2 may be formed through atomic layer deposition (ALD). Referring to FIG. 5H, the gate electrode 131 is formed on the second charge blocking layer CB2. Through the above processes, the non-volatile memory device including the charge trap layer CT including the nanocrystal regions 125 and the isolation regions 126 may be manufactured.

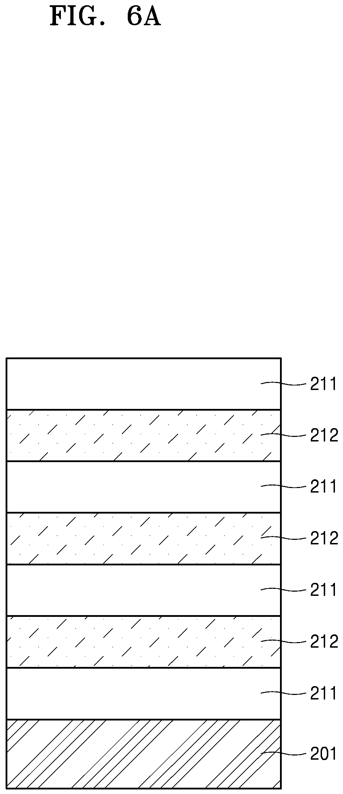

Next, referring to FIGS. 6A to 6I, a method of manufacturing a non-volatile memory device according to an embodiment is described.

Referring to FIG. 6A, first layers 211 and mold layers 212 are alternately stacked on a substrate 201 in a direction perpendicular to the substrate 201 (e.g., the top surface of the substrate 201). The first layer 211 may include, for example, SiN. The mold layer 212 may include MO (where M represents a metal), and M includes at least one from among Hf, Ti, Zr, U, Th, Cr, Ga, V, Sc, Lu, Yb, Er, Ho, Dy, Gd, Y, Nd, Ce, La, Ni, Mg, Cu, Zn, Co, Fe, Mn, Ca, Eu, Sr, and Sm. The mold layer 212 may include, for example, $HfO_2$. The first layer 211 may include nitride, and the mold layer 212 may include oxide such that selective etching may be effectively performed when the mold layer 212 is removed later.

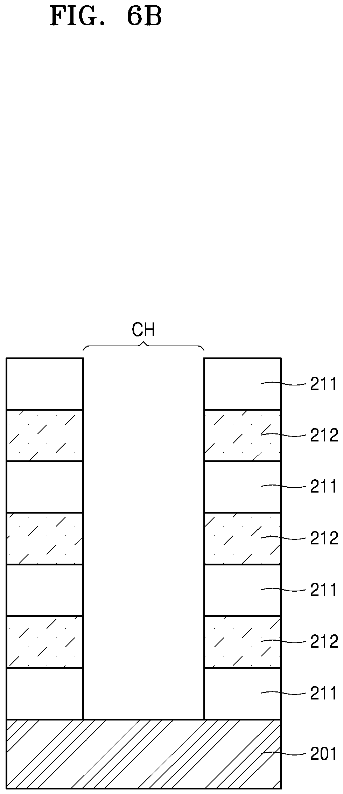

Referring to FIG. 6B, a channel hole CH is formed to penetrate the stack structure including the first layers 211 and the mold layers 212. The channel hole CH may be formed by anisotropically etching the first layers 211 and the mold layers 212.

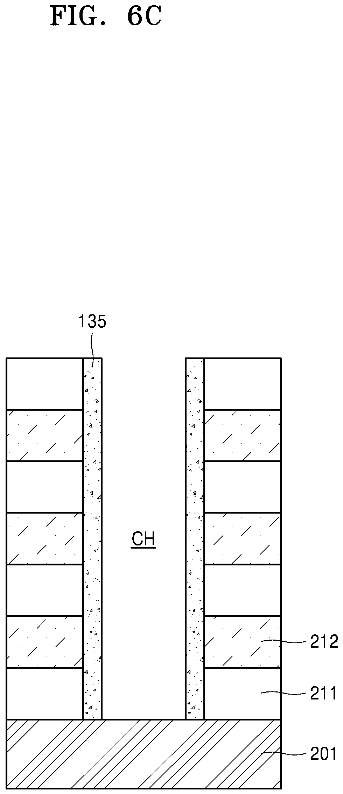

Referring to FIG. 6C, a sacrificial layer 135 may be formed in the channel hole CH. The sacrificial layer 135 may include, for example, at least one from among Si, B, and Al.

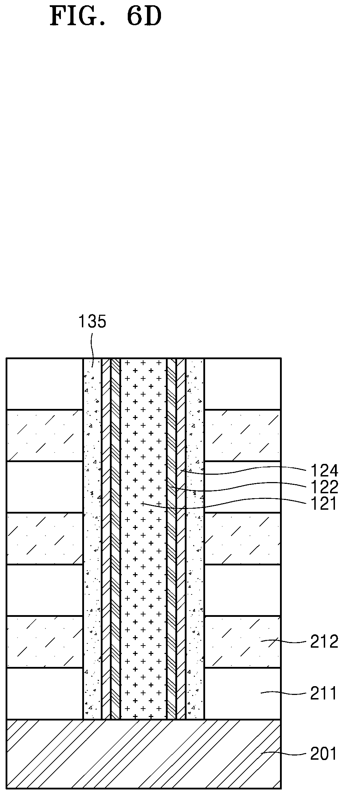

Referring to FIG. 6D, a charge tunneling layer 124 and a channel layer 122 may be formed on the sacrificial layer 135. A pillar 121 may be formed in the channel layer 122.

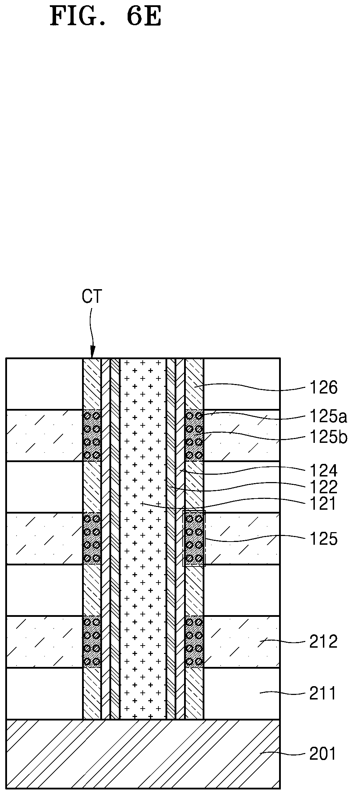

Referring to FIG. 6E, when the structure of FIG. 6D is thermally treated in an oxygen atmosphere, a reaction between the sacrificial layer 135 and the mold layer 212 results in spinodal decomposition, thereby forming nanocrystal regions 125 in the sacrificial layer 135. A simple oxidation reaction occurs between the first layer 211 and the sacrificial layer 135, and thus, the isolation regions 126 are formed. The stack structure, in which the nanocrystal regions 125 and the isolation regions 126 are alternately formed, may form the charge trap layer CT. The nanocrystal region 125 may include nanocrystals 125a and a matrix 125b surrounding the nanocrystals 125a. The isolation region 126 may be an amorphous region.

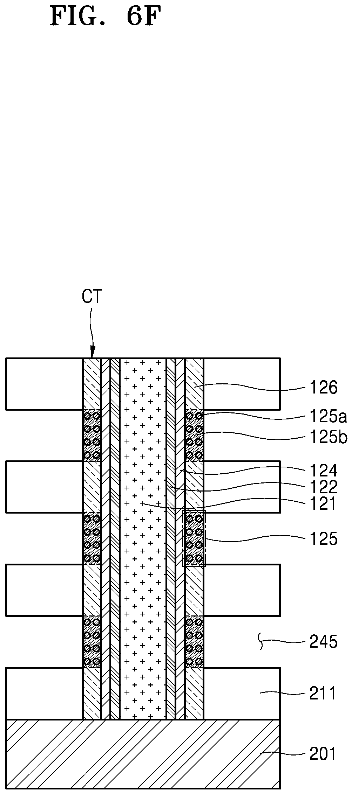

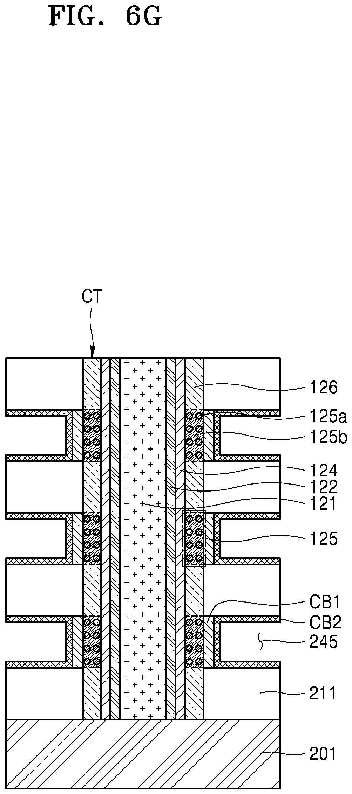

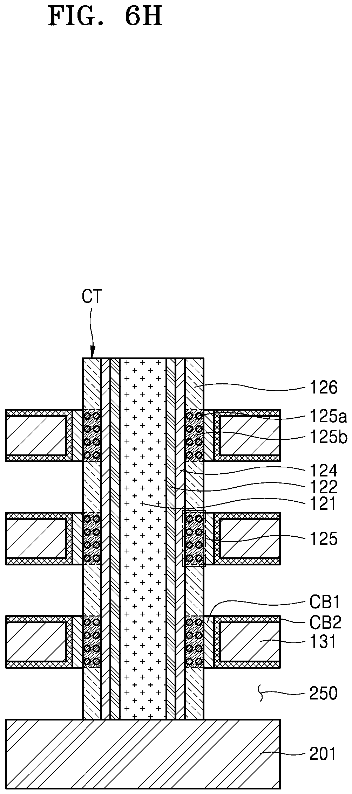

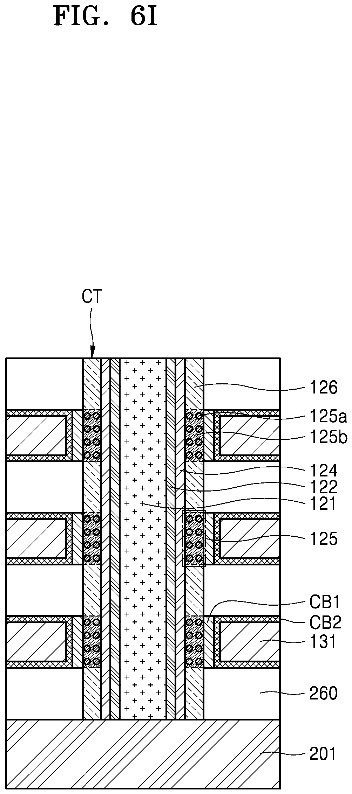

Referring to FIG. 6F, the mold layer 212 is removed through selective etching. Here, because the first layer 211 includes nitride and the mold layer 212 includes oxide, the mold layer 212 may be effectively and selectively etched. Referring to FIG. 6G, in the space 245 where the mold layer 212 is removed, the first charge blocking layer CB1 and the second charge blocking layer CB2 are formed. Referring to FIG. 6H, the gate electrode 131 is formed on the second charge blocking layer CB2. Then, the first layer 211 is removed. Referring to FIG. 6I, a gate insulating layer 260 is formed in the space 250 (see FIG. 6H) where the first layer 211 is removed. The gate insulating layer 260 may include, for example, $SiO_2$, metal organic framework, or BN. The metal organic framework may include, for example, UiO-66 or ZIF-8. BN may include amorphous BN or amorphous BCN. In the present embodiment, the gate insulating layer 260 is formed instead of the first layer 211 after the mold layer 212 is selectively etched by the first layer 211, allowing for a wider selection of materials forming the gate insulating layer 260. As a result, the gate insulating layer 260 may be formed using $SiO_2$ or a low-k material with a smaller dielectric constant than $SiO_2$. Because a low-k material such as BN may be applied to a gate insulating layer and BN features a low dielectric constant and high Young's modulus, the non-volatile memory device according to an embodiment may be used in integrated circuits of various electronic apparatuses, thereby reducing parasitic capacitance. Furthermore, because of the excellent mechanical properties of BN, such as hardness and Young's modulus, the non-volatile memory device may be physically/mechanically stable even when BN is formed into thin layers.

In the non-volatile memory device manufactured according to the manufacturing method according to an embodiment, the path of lateral charge loss is blocked as the nanocrystal regions 125 of the charge trap layer CT are surrounded by the first charge blocking layer CB1, the second blocking layer CB2, the gate insulating layer 132 and the gate insulating layer 260, and the isolation regions 126; thus, lateral charge loss may decrease.

The non-volatile memory device may include a plurality of memory cells that retain information even when the power supply is interrupted and may access the stored information once power is restored. The non-volatile memory device may be widely applied to mobile phones, digital cameras, personal digital assistants (PDAs), portable computer devices, and the like.

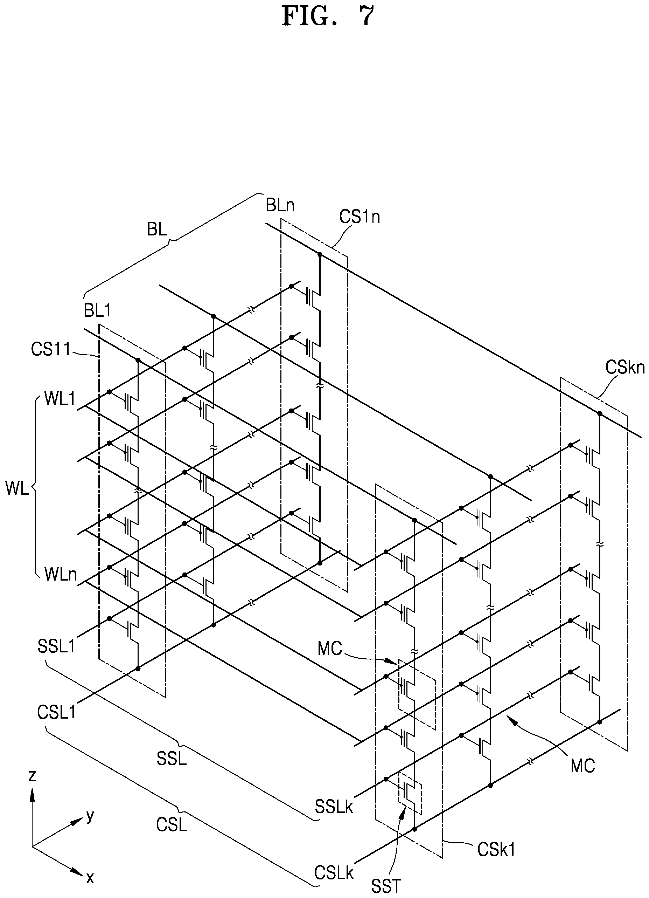

FIG. 7 is a circuit diagram of a non-volatile memory device, according to an embodiment. The non-volatile memory device may include k*n cell strings CS (refer to FIG. 1) arranged in a matrix form, and depending on their positions in rows and columns, the cell strings CS may be referred to as cell strings CSij ($1 \leq i \leq k$, $1 \leq j \leq n$). Each cell string CSij may be connected to a bit line BL, a string selection line SSL, a word line WL, and a common source line CSL.

Each cell string CSij includes memory cells MC and a string selection transistor SST. The memory cells MC and the string selection transistor SST of each cell string CSij may be stacked in a height direction.

Rows of the cell strings CS are respectively connected to different string selection lines SSL1 to SSLk. For example, the string selection transistors SST of the cell strings CS11 to CS1n are commonly connected to the string selection line SSL1. The string selection transistors SST of the cell strings CSk1 to CSkn are commonly connected to the string selection line SSLk.

Columns of the cell strings CS are respectively connected to different bit lines BL1 to BLn. For example, the memory cells MC and the string selection transistors SST of the cell strings CS11 to CSk1 may be commonly connected to the bit line BL1, and the memory cells MC and the string selection transistors SST of the cell strings CS1n to CSkn may be commonly connected to the bit line BLn.

Rows of the cell strings CS are respectively connected to different common source lines CSL1 to CSLk. For example, the string selection transistors SST of the cell strings CS11 to CS1n may be commonly connected to the common source line CSL1, and the string selection transistors SST of the cell strings CSk1 to CSkn may be commonly connected to the common source line CSLk.

Memory cells MC, which are at the same height from the substrate or the string selection transistors SST, may be commonly connected to one word line WL, and the memory cells MC at different heights may be respectively connected to different word lines WL1 to WLn.

The illustrated circuit structure is a non-limiting example. For example, the number of rows of the cell strings CS may increase or decrease. As the number of rows of the cell string CS changes, the number of string selection lines connected to the rows of the cell string CS and the number of cell strings CS connected to one bit line BL may also change. As the number of rows of the cell string CS changes, the number of common source lines connected to the rows of the cell strings CS may also change.

The number of columns of the cell strings CS may increase or decrease. As the number of columns of the cell string CS changes, the number of bit lines BL connected to the columns of the cell string CS and the number of cell strings CS connected to a string selection line may also change.

The height of the cell string CS may increase or decrease as well. For example, the number of memory cells MC stacked on each cell string CS may increase or decrease. As the number of memory cells MC stacked on each cell string CS changes, the number of word lines WL may also change. For example, the number of string selection transistors provided to each cell string CS may increase. As the number of string selection transistors provided to each cell string CS changes, the number of string selection lines or common source lines may also change. When the number of string selection transistors SST increases, the string selection transistors SST may be stacked in the same form as the memory cells MC.

For example, reading and writing operations may be performed in units of rows of the cell strings CS. The cell strings CS may be selected in a unit of rows by the common source line CSL and by the string selection lines SSL. In addition, a voltage may be applied to at least two of the common source lines CSL as a single unit. Alternatively, a voltage may be applied to all of the common source lines CSL as a single unit.

In the selected row of the cell strings CS, reading and writing operations may be performed in units of pages. The page may be one row of memory cells connected to one word line WL. In the selected row of the cell strings CS, the memory cells may be selected by the word lines WL in units of pages. For example, each gate electrode 131 of FIG. 1 may be connected to one of the word line WL and the string selection line SSL.

The memory cell MC may have a circuit structure in which the charge trap layer CT is connected to a transistor including the gate electrode 131, the gate insulating layer 132, and the channel layer 122.

The memory cells MC may be continuously arranged in the vertical direction (the Z direction), thus forming the cell string CS. As illustrated in the circuit diagram of FIG. 7, ends of the cell string CS may be connected to the common source line CSL and the bit line BL, respectively. As voltages are applied to the common source line CSL and the bit line BL, programming, reading, and erasing operations may be performed in the memory cells MC.

For example, when a memory cell MC to be written is selected, a gate voltage value of the selected memory cell MC is adjusted to ensure no channel formation, that is, to turn off channels, while gate voltage values of unselected memory cells are adjusted to turn on channels. Accordingly, charges may tunnel through the charge tunneling layer 124 and be stored in the charge trap layer CT of the selected memory cell MC by the voltage applied to the common source line CSL and the bit line BL, and thus, desired information, 1 or 0, may be written on the selected memory cell MC.

Similarly, the reading operation may be performed in the selected memory cell MC. That is, after the gate voltage for each gate electrode 131 is adjusted to turn off the channel in the selected memory cell MC and to turn on the channel in unselected memory cells, the current flowing in the selected memory cell MC is measured using the voltage Vread applied between the common source line CSL and the bit line BL such that the state of the memory cell (1 or 0) may be identified.

The non-volatile memory device 100 has a structure in which cells are vertically connected. When information is stored, charges may diffuse in the vertical direction and migrate to adjacent cells, affecting the operations of the adjacent cells. However, in the non-volatile memory device 100, the charge trap layer CT including the nanocrystal regions 125 and the isolation regions 126 helps reduce lateral charge loss, and thus, negative effects on the operation of adjacent cells may decrease.

The non-volatile memory device may exhibit the aforementioned advantages and may be applied to a variety of electronic apparatuses.

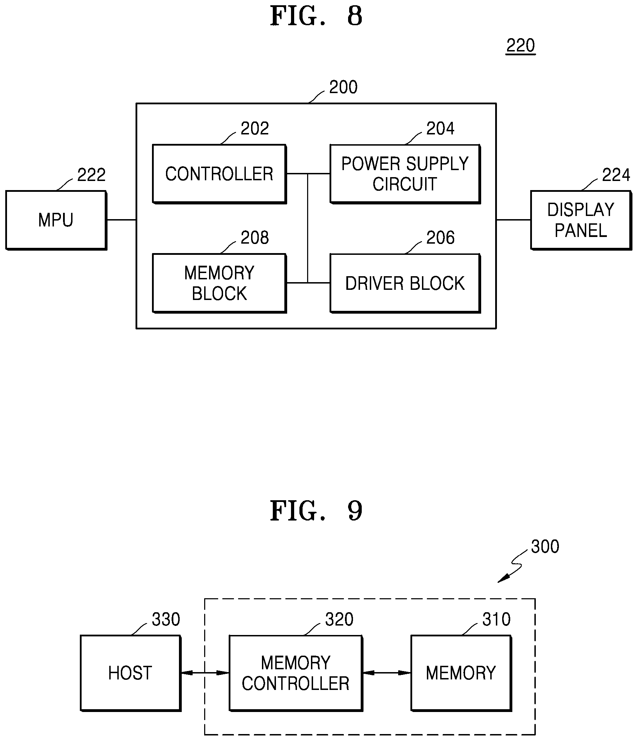

FIG. 8 is a schematic block diagram of a display driver integrated circuit (IC) (DDI) 200 and a display apparatus 220 including the DDI 200, according to an embodiment. Referring to FIG. 8, the DDI 200 may include a controller 202, a power supply circuit 204, a driver block 206, and a memory block 208. The controller 202 receives and decodes commands from a main processing unit (MPU) 222 and controls individual blocks of the DDI 200 to implement operations according to the commands. The power supply circuit 204 generates a driving voltage in response to the control of the controller 202. The driver block 206 may use the driving voltage generated by the power supply circuit 204 in response to the control of the controller 202, thus driving a display panel 224. The display panel 224 may be, for example, a liquid crystal display panel, an organic light-emitting device (OLED) display panel, or a plasma display panel. The memory block 208 may temporarily store commands that are input to the controller 202 or control signals that are output from the controller 202 or may store necessary data and may include a memory, such as random access memory (RAM) or read only memory (ROM). For example, the memory block 208 may include the non-volatile memory device 100 according to the one or more embodiments described above.

FIG. 9 is a block diagram of an electronic apparatus 300 according to an embodiment. Referring to FIG. 9, the electronic apparatus 300 includes a memory 310 and a memory controller 320. In response to a request from a host 330, the memory controller 320 may control the memory 310 to read data from the memory 310 and/or write data to the memory 310. The memory 310 may include the non-volatile memory device 100 according to the one or more embodiments described above.

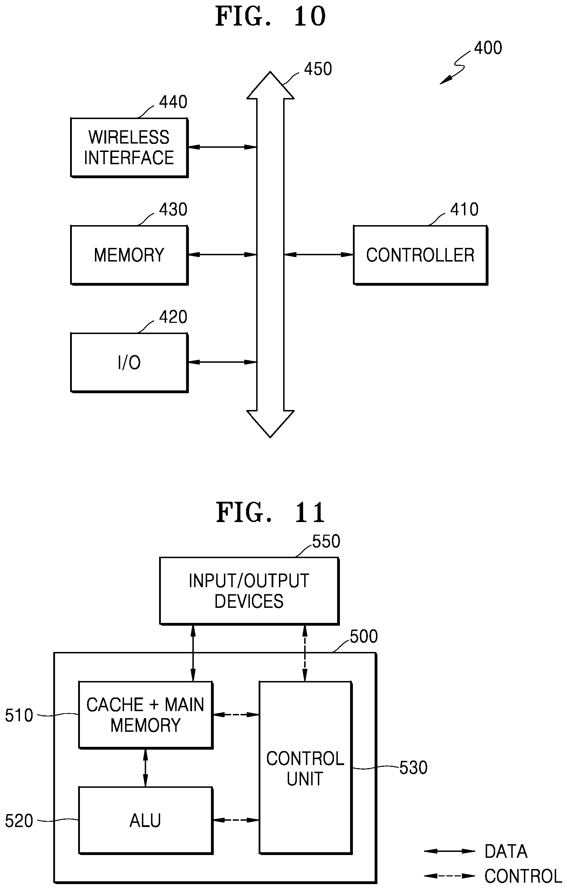

FIG. 10 is a block diagram of an electronic apparatus 400 according to an embodiment. Referring to FIG. 10, the electronic apparatus 400 may constitute a wireless communication device or a device capable of transmitting and/or receiving information under the wireless environment. The electronic apparatus 400 may include a controller 410, an input/output device (I/O) 420, a memory 430, and a wireless interface 440, all of which are interconnected via a bus 450.

The controller 410 may include at least one from among a microprocessor, a digital signal processor, and a similar processing device. The I/O 420 may include at least one from among a keypad, a keyboard, and a display. The memory 430 may be used to store the commands executed by the controller 410. For example, the memory 430 may be used to store user data. The electronic apparatus 400 may use the wireless interface 440 to transmit/receive data through a wireless communication network. The wireless interface 440 may include an antenna and/or a wireless transceiver. In some embodiments, the electronic apparatus 400 may be used with communication interface protocols of third-generation communication systems, such as Code Division Multiple Access (CDMA), Global System for Mobile Communications (GSM), North American Digital Cellular (NADC), Extended-Time Division Multiple Access (E-TDMA), and/or Wide Band Code Division Multiple Access (WCDMA). The memory 430 of the electronic apparatus 400 may include the non-volatile memory device 100 according to the one or more embodiments described above.

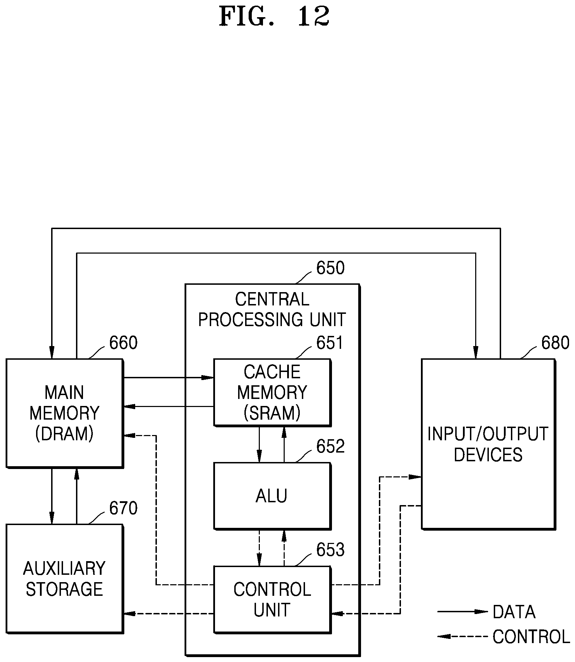

FIGS. 11 and 12 are schematic conceptual views of a device architecture applicable to an electronic apparatus, according to an embodiment.

Referring to FIG. 11, an electronic device architecture 500 may include a memory unit 510 and a control unit 530, and may further include an arithmetic logic unit (ALU) 520. The memory unit 510, the ALU 520, and the control unit 530 may be electrically connected. For example, the electronic device architecture 500 may be implemented as a single chip that includes the memory unit 510, the ALU 520, and the control unit 530. In detail, the memory unit 510, the ALU 520, and the control unit 530 may be interconnected through metal lines on-chip and may directly communicate with each other. The memory unit 510, the ALU 520, and the control unit 530 may be monolithically integrated on a single substrate (e.g., the substrate 101 of FIG. 1), thus forming a single chip. Input/output devices 550 may be connected to the electronic device architecture (chip) 500. In addition, the memory unit 510 may include both a main memory and a cache memory. The electronic device architecture (chip) 500 may be an on-chip memory processing unit. The memory unit 510, the ALU 520, and/or the control unit 530 may each independently include the non-volatile memory device 100.

Referring to FIG. 12, a cache memory 651, an ALU 652, and a control unit 653 may form a central processing unit (CPU) 650, and the cache memory 651 may include static random access memory (SRAM). Separate from the CPU 650, a main memory 660 and an auxiliary storage 670 may be included, and input/output devices 680 may also be included. The main memory 660 may be, for example, dynamic random access memory (DRAM) and may include the non-volatile memory device 100 according to the one or more embodiments described above.

In some cases, the electronic device architecture may be configured such that computing unit devices and memory unit devices are adjacent to one another in a single chip without regard to sub-unit divisions.

A non-volatile memory device according to one or more embodiments may be applied to various user devices, for example, computers, handheld computers, ultra mobile PCs (UMPC), workstations, net-books, personal digital assistants (PDAs), portable computers, web tablets, wireless phones, mobile phones, smartphones, digital cameras, digital audio recorders, digital audio players, digital picture recorders, digital picture players, digital video recorders, digital video players, devices capable of receiving/transmitting information in wireless environments, and home networks.

The non-volatile memory device according to one or more embodiments includes a charge trap layer, in which nanocrystal regions and isolation regions are alternately arranged, interrupting charge migration between memory cells. As a result, the charge retention may be enhanced in the non-volatile memory device despite higher integration and size reduction of the non-volatile memory device.

An electronic apparatus according to one or more embodiments includes a compact and highly integrated non-volatile memory device and thus stably exhibits high capacity and high performance.

A method of manufacturing a non-volatile memory device according to one or more embodiments is provided, the non-volatile memory device including a charge trap layer in which nanocrystal regions and isolation regions are alternated.

It should be understood that the example embodiments described herein should be considered in a descriptive sense only and not for purposes of limitation. Descriptions of features or aspects within each embodiment should typically be considered as available for other similar features or aspects in other embodiments. While one or more non-limiting example embodiments have been described with reference to the figures, it will be understood by those of ordinary skill in the art that various changes in form and details may be made therein without departing from the scope of the present disclosure.

**Claims**

1. A non-volatile memory device comprising:

   a substrate;
   a gate electrode and a gate insulating layer that are alternately stacked in a vertical direction perpendicular to a top surface of the substrate;
   a channel hole that penetrates the gate electrode and the gate insulating layer in the vertical direction;
   a charge trap layer inside the channel hole;
   a charge tunneling layer in the charge trap layer; and
   a channel layer in the charge tunneling layer,
   wherein the charge trap layer comprises a nanocrystal region and an isolation region that are alternately arranged in the vertical direction.

2. The non-volatile memory device of claim 1, wherein the nanocrystal region is at a location corresponding to the gate electrode, and the isolation region is at a location corresponding to the gate insulating layer.

3. The non-volatile memory device of claim 1 or 2, wherein the nanocrystal region comprises MO (where M represents a metal) nanocrystals or MAO (where M represents a metal) nanocrystals, and A comprises silicon (Si), boron (B), or aluminum (Al).

4. The non-volatile memory device of claim 3, wherein M comprises at least one from among hafnium (Hf), titanium (Ti), zirconium (Zr), uranium (U), thorium (Th), chromium (Cr), gallium (Ga), vanadium (V), scandium (Sc), lutetium (Lu), ytterbium (Yb), erbium (Er), holmium (Ho), dysprosium (Dy), gadolinium (Gd), europium (Eu), samarium (Sm), yttrium (Y), neodymium (Nd), cerium (Ce), lanthanum (La), nickel (Ni), magnesium (Mg), copper (Cu), zinc (Zn), cobalt (Co), iron (Fe), manganese (Mn), calcium (Ca), and strontium (Sr).

5. The non-volatile memory device of any preceding claim, wherein the nanocrystal region comprises a plurality of nanocrystals and a matrix surrounding the plurality of nanocrystals, and optionally wherein the matrix comprises $MSiO_2$ (where M represents a metal), $SiO_2$ doped with M, or $SiO_2$.

6. The non-volatile memory device of any preceding claim, wherein a thickness of the channel hole at a vertical height of the nanocrystal region in a diameter direction of the channel hole is in a range from 3 nm to 20 nm.

7. The non-volatile memory device of any preceding claim, wherein a thickness of the isolation region of the charge trap layer in the vertical direction is in a range from 5 nm to 25 nm.

8. The non-volatile memory device of any preceding claim, wherein, in the nanocrystal region, a quotient of a total volume of a plurality of nanocrystals in the nanocrystal region divided by a volume of the nanocrystal region is at least 20%.

9. The non-volatile memory device of any preceding claim, wherein the isolation region comprises an amorphous region.

10. The non-volatile memory device of any preceding claim, wherein the gate insulating layer comprises $SiO_2$, a metal organic framework, or boron nitride.

11. The non-volatile memory device of any preceding claim, further comprising a charge blocking layer between the charge trap layer and the gate electrode.

12. The non-volatile memory device of any preceding claim, wherein the nanocrystal region comprises a plurality of nanocrystals, and a distance between the plurality of nanocrystals is in a range from 1 nm to 25 nm.

13. An electronic apparatus comprising:

a non-volatile memory device according to any preceding claim; and
a memory controller configured to control the non-volatile memory device to read data from the non-volatile memory device or write data to the non-volatile memory device.

14. A method of manufacturing a non-volatile memory device, the method comprising:

alternately stacking, on a substrate, a gate insulating layer and a mold layer in a vertical direction perpendicular to a top surface of the substrate;
forming a channel hole that penetrates the gate insulating layer and the mold layer in the vertical direction;
forming a sacrificial layer inside the channel hole;
forming a charge tunneling layer in the sacrificial layer;
forming a channel layer in the charge tunneling layer;
forming, after forming the channel layer, a nanocrystal region in the sacrificial layer at a position corresponding to the mold layer, by inducing a reaction between the mold layer and the sacrificial layer via heating;
forming an isolation region between the gate insulating layer and the mold layer;
removing the mold layer; and
forming a gate electrode in a space where the mold layer is removed,
wherein the nanocrystal region and the isolation region are alternately arranged in the vertical direction such that a charge trap layer is formed.

15. The method of claim 14, wherein the sacrificial layer comprises at least one from among silicon (Si), boron (B), and aluminum (Al).

# FIG. 1

# FIG. 2

# FIG. 3

# FIG. 4

FIG. 5A

— 132

— 130

— 132

— 130

— 132

— 130

— 132

— 101

# FIG. 5B

# FIG. 5C

135

CH

130

132

101

# FIG. 5D

135

124
122
121

130

132

101

# FIG. 5E

CT

126
125a
125b
124
122
121
125
130
132
101

# FIG. 5F

CT

126

125a
125b

124
122
121

125

145

132

101

# FIG. 5G

CT

126
125a
125b
124
122
121
125
CB1
CB2
145
132
101

# FIG. 5H

CT

126
125a
125b
124
122
121
125

CB1
CB2
131
132
101

# FIG. 6A

211

212

211

212

211

212

211

201

# FIG. 6B

CH

211

212

211

212

211

212

211

201

# FIG. 6C

135

CH

212

211

201

## FIG. 6D

# FIG. 6E

CT

126
125a
125b
124
122
121
125
212
211
201

# FIG. 6F

CT

126

125a
125b

124
122
121

125

245

211

201

# FIG. 6G

CT

126
125a
125b
124
122
121
125
CB1
CB2
245
211
201

# FIG. 6H

CT

126

125a
125b

124
122
121

125

CB1
CB2
131

250

201

# FIG. 6I

CT

126

125a
125b

124
122
121

125

CB1
CB2
131

260

201

# FIG. 7

# FIG. 8

<u>220</u>

200

| | 202 | 204 | |
|---|---|---|---|
| 222 | CONTROLLER | POWER SUPPLY CIRCUIT | 224 |
| MPU | | | DISPLAY PANEL |
| | 208 | 206 | |
| | MEMORY BLOCK | DRIVER BLOCK | |

# FIG. 9

300

| 330 | 320 | 310 |
|---|---|---|
| HOST | MEMORY CONTROLLER | MEMORY |

# FIG. 10

400

450

440

WIRELESS
INTERFACE

430

MEMORY

410

CONTROLLER

420

I/O

# FIG. 11

550

INPUT/OUTPUT
DEVICES

500

510

CACHE + MAIN
MEMORY

530

CONTROL
UNIT

520

ALU

DATA

CONTROL

# FIG. 12

**EP 4 608 085 A1**

Europäisches
Patentamt

European
Patent Office

Office européen
des brevets

# EUROPEAN SEARCH REPORT

**Application Number**

EP 25 15 0075

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2022/320305 A1 (HAN JAE HYUN [KR] ET AL) 6 October 2022 (2022-10-06) | 1,2,5-13 | INV.<br>H10B43/27 |
| Y | * paragraphs [0049] - [0080]; figures 4A,4B * | 3,4 | H10D64/01 |
| A | | 14,15 | |
| X | US 2018/047743 A1 (KWON THOMAS JONGWAN [US]) 15 February 2018 (2018-02-15) * paragraphs [0019] - [0029]; figure 2K * | 1 | |
| Y | US 2022/238672 A1 (LEE MINHYUN [KR] ET AL) 28 July 2022 (2022-07-28) * paragraph [0011]; figures 1,2 * | 3,4 | |

**TECHNICAL FIELDS SEARCHED (IPC)**

H10B
H10D

The present search report has been drawn up for all claims

| Place of search | Date of completion of the search | Examiner |
|---|---|---|
| Munich | 2 June 2025 | Bräckelmann, Gregor |

**ANNEX TO THE EUROPEAN SEARCH REPORT
ON EUROPEAN PATENT APPLICATION NO.**   EP 25 15 0075

This annex lists the patent family members relating to the patent documents cited in the above-mentioned European search report.
The members are as contained in the European Patent Office EDP file on
The European Patent Office is in no way liable for these particulars which are merely given for the purpose of information.

02-06-2025

| Patent document cited in search report | Publication date | Patent family member(s) | Publication date |
|---|---|---|---|
| US 2022320305 A1 | 06-10-2022 | CN 115206980 A | 18-10-2022 |
| | | KR 20220138291 A | 12-10-2022 |
| | | US 2022320305 A1 | 06-10-2022 |
| | | US 2024313073 A1 | 19-09-2024 |
| US 2018047743 A1 | 15-02-2018 | NONE | |
| US 2022238672 A1 | 28-07-2022 | CN 114792692 A | 26-07-2022 |
| | | EP 4040489 A1 | 10-08-2022 |
| | | US 2022238672 A1 | 28-07-2022 |

EPO FORM P0459

For more details about this annex : see Official Journal of the European Patent Office, No. 12/82